# EUROPEAN PATENT APPLICATION

(11) **EP 4 012 746 A1**
(43) Date of publication of application: **15.06.2022**
(21) Application number: 20212374.1
(22) Date of filing: 08.12.2020
(51) Int. Cl.: H01J 37/34, C23C 14/34

(54) **COZRTA(X) SPUTTERING TARGET WITH IMPROVED MAGNETIC PROPERTIES**

(71) Applicant: Materion Advanced Materials Germany GmbH, 63755 Alzenau (DE)
(72) Inventor: KONIETZKA, Uwe, 63826 Geiselbach (DE); SCHLOTT, Martin, 63075 Offenbach (DE)
(74) Representative: Kador & Partner PartG mbB

(57) **Abstract**

The present invention relates to a sputtering target comprising an alloy of Co, Zr, Ta and, optionally, one or more further element(s) X from the group of Mo, Pd, Ni, Ti, V, W, and B, wherein the target has a maximum magnetic permeability µₘₐₓ of 50 or lower, to a process for producing said target, to a sputtering process using said target and to a layer produced by said sputtering process.

## Description

The present invention relates to a target for sputtering with a magnetron cathode, the target being based on a Co alloy with additives including Zr, Ta and, optionally, at least one of the elements Pt, Pd, Ni, Ti, V, W, and B.

In the process of magnetron cathode sputtering, permanent magnets are installed behind the target (the cathode) to optimize the sputtering process. These magnets are arranged in such a way that a magnetic field forms in front of the target, i.e., in the discharge space. This magnetic field has the effect of localizing the discharge plasma. The area of the target surface over which the plasma is localized is subjected to more active sputtering, as a result of which an erosion groove (or race track) is formed there.

In the case of ferromagnetic targets, such as CoZrTa(X) alloys, there are two main problems which occur in this situation:
First, the magnetic flux of the permanent magnets is focused within the target, so that only a small amount of flux can penetrate into the discharge space. This problem therefore requires the use of very thin ferromagnetic targets - or extremely strong magnet sets.
Second, the local reduction in the cross section of the target (erosion groove) which occurs when cathodic sputtering is carried out with ferromagnetic targets has the effect of increasing the magnetic flux directly above the erosion groove. As a result, there is a local increase in ionization of the sputtering gas and also a local increase in the sputtering rate. The erosion groove therefore becomes increasingly narrow, as the sputtering progresses, and this is associated with a very low rate of target material utilization.

Improved magnetic field geometries and higher magnetic field penetration can be achieved by means of complicated target designs. The magnetic resistance in the target can be increased and a larger field produced in the discharge space by providing the target with slots perpendicular to the direction of the magnetic field (K. Nakamura et al.: IEEE Transactions on Magnetics, Vol. MAG-18, pp. 1,080-1,082, 1982).

Kukla et al. (IEEE Transactions on Magnetics, Vol. MAG-23, pp. 137-139, 1987) describe a cathode for ferromagnetic materials, which consists of several individual targets, arranged in two planes one above the other, in order to obtain a stronger magnetic field. These designs are more expensive, however, and make the operation of magnetron cathode sputtering more difficult.

It is the object of the present invention to provide a target material based on an CoZrTa(X) alloy which has improved magnetic properties when used for magnetron cathode sputtering, i.e. which allows for an enhanced magnetic field penetration through the target material when used in conjunction with magnetron cathodes.

The present invention is based on the finding that such a sputtering target can be provided if the CoZrTa(X) alloy is thermally treated at high temperature so that the magnetic permeability of the alloy is reduced.

Accordingly, the present invention relates to a sputtering target comprising, or consisting of, an alloy comprising, or consisting of, Co, Zr, Ta and optionally one or more further element X from the group of Mo, Pd, Ni, Ti, V, W, and B, wherein the target has a maximum magnetic permeability µₘₐₓ of 50 or lower.

Preferably, the total amount in at.% of element(s) X is smaller than the larger one of the two additions of Ta or Zr in at.%,
The sputtering target of the invention has a reduced magnetic permeability and hence allows for an increased magnetic flux through the target, so that the above described main problems in magnetron sputtering can be avoided or at least alleviated.

Targets of the invention can be manufactured to an increased thickness which provides a longer target lifetime at the user, better film uniformity and a more constant sputtering rate over target life.

Zr is preferably present in the alloy in an amount of from 2 to 8 at.%, more preferably from 3 to 7 at.%.

Ta is preferably present in the alloy in an amount of from 2 to 8 at.%, more preferably from 3 to 7 at.%.

If in the alloy one or more further optional element X from the group of Mo, Pd, Ni, Ti, V, W, and B is present, this is preferably in a total amount of element(s) X of up to 7 at.%, more preferably of up to 3 at.%.

Preferably, if a further element X from the group of Mo, Pd, Ni, Ti, V, W, and B is present in the alloy it is only one of these elements.

Preferably, in the sputtering target of the invention Co is present in the CoZrTa(X) alloy in an amount of at least 75 at.%, more preferably at least 90 at.%.

Preferably, the CoZrTa(X) alloy consists of Zr, Ta, optionally one or more further element X from the group of Mo, Pd, Ni, Ti, V, W, and B, and Co, i.e. Co makes up the remainder of the atoms in the alloy.

The sputtering target of the invention preferably has a maximum magnetic permeability µₘₐₓ of 60, more preferably of 40 or lower.

The maximum magnetic permeability µₘₐₓ is usually not less than 10 or 20.

Further preferred, the sputtering target of the invention has a saturation magnetization Js, measured as Js=J(H=60kA/m) of 0.8 T or below.

The saturation magnetization Js is usually not less than 0.5 T.

Preferably, the magnetic pass through flux (PTF) measured according to ATSM F2086-01 of the target is 20 % or higher, more preferably is 25 % or higher.

The invention further relates to a process for producing a sputtering target material comprising an alloy of Co, Zr, Ta and, optionally, one further element X from the group of Mo, Pd, Ni, Ti, V, W, and B, wherein the process involves heating the alloy to a temperature of at least 700 °C, more preferably to at least 750 °C and still more preferably at least 800 °C.

Preferably, heating is performed to a temperature of at most 1000°C, more preferably at most 900 °C.

Usually, heating is done by introducing the alloy into an oven pre-heated to the desired temperature.

Heating of the alloy to the temperature as prescribed above is preferably performed for a time of 10 to 60 hours, more preferably 12-48 hours.

Furthermore, the invention relates to a magnetron sputtering process in which a sputtering target in any one of the embodiments described herein is used, to a layer produced by said sputtering process, and to the use of a sputtering target in any one of the embodiments described herein for magnetron sputtering.

The present invention will further be illustrated on the basis of the following examples with reference to the figures, which show:
Fig. 1: Magnetic hysteresis curve of a CoZrTa alloy not in accordance with the invention,
Fig. 2: Magnetic hysteresis curve of a CoZrTa alloy in accordance with the invention.

### Definitions/Measurement methods

### a) Measurement of the Magnetic Properties

Magnetization curves were measured to compare the as rolled and the heat treated material using Remagraph C of Magnet-Physik in accordance with DIN EN 60404-4.

Measurement of PTF was performed according to ATSM F2086-01 in the center of 8mm thick test pieces of 653x133mm size

### Examples

A CoZrTa alloy with 91.5 at.% Co, 4 at.% Zr and 4.5 at% Ta was produced by conventional vacuum induction melting and casting, followed by hot rolling at 1200°C to obtain a plate with dimensions 653 x 133 x 8 mm.

The plate was then subjected to a heat treatment at 860°C for 26h followed by air cooling, which resulted in a significant increase of the magnetic pass through flux (PTF): PTF before the heat treatment was 10.7 %, whereas PTF after heat treatment was 30.2 %.

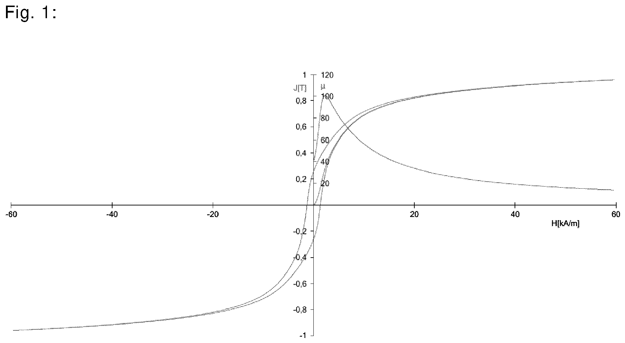

As can be seen from Fig. 1, untreated material shows a maximum permeability of ~100 at magnetic fields of ~3kA/m together with a saturation magnetization of 960 mT. As a consequence, only up to 4 mm thick target can be ignited on standard cathodes.

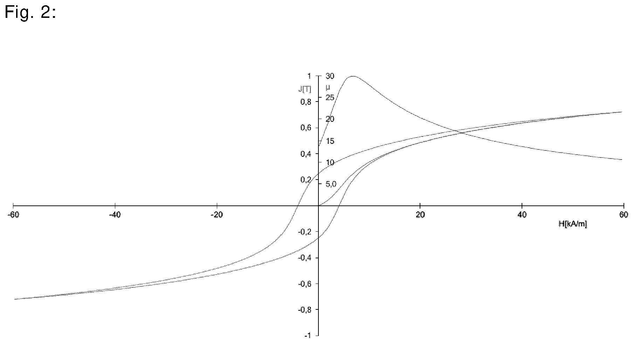

In contrast, as can be seen from Fig. 2, the heat treated alloy according to the invention shows a 3x lower maximum permeability of ~30 at considerably higher magnetic fields of 15kA/m together with a lowered saturation magnetization of 721mT. Igniting a 6 mm target on the same cathode was no problem.

## Claims

1. Sputtering target comprising an alloy of Co, Zr, Ta and, optionally, one or more further element(s) X from the group of Mo, Pd, Ni, Ti, V, W, and B, wherein the target has a maximum magnetic permeability µₘₐₓ of 50 or lower.

2. Sputtering target according to claim 1 wherein Ta is present in the alloy in an amount of from 2 to 8 at.%.

3. Sputtering target according to claim 1 or 2 wherein Zr is present in an amount of from 2 to 8 at.%.

4. Sputtering target according to any one of the preceding claims wherein one or more further element(s) X from the group of Mo, Pd, Ni, Ti, V, W, and B are present in the alloy in a total amount of up to 7 at.%.

5. Sputtering target according to any one of the preceding claims wherein the alloy consists of Co, Zr, Ta and, optionally, one or more further element(s) X from the group of Mo, Pd, Ni, Ti, V, W, and B.

6. Sputtering target according to any one of the preceding claims wherein the target has a maximum magnetic permeability µₘₐₓ of 60, preferably 40 or lower.

7. Sputtering target according to any one of the preceding claims wherein the a 8mm target plate has a magnetic pass of at least 20%.

8. Process for producing a sputtering target comprising an alloy of Co, Zr, Ta and, optionally, one or more further element(s) X from the group of Mo, Pd, Ni, Ti, V, W, and B, wherein the process involves heating the alloy to a temperature in the range of 700 to 1000°C, preferably of 800 to 900°C.

9. Process according to claim 9 wherein the alloy is heated for a time of 10 to 60 hours, preferably 12-48 hours.

10. Magnetron sputtering process in which a sputtering target according to any one of claims 1 to 7 is used.

11. Layer produced by a sputtering process according to claim 10.

12. Use of a sputtering target according to any one of claims 1 to 7 for magnetron sputtering.
